# EUROPEAN PATENT APPLICATION

(11) **EP 2 230 036 A1**
(43) Date of publication of application: **22.09.2010**
(21) Application number: 10154519.2
(22) Date of filing: 24.02.2010
(51) Int. Cl.: B22F 1/00, C09D 11/00

(54) **Metal nanoparticle composition with improved adhesion**

(30) Priority: 12.03.2009 US 402950
(71) Applicant: Xerox Corporation, Rochester, New York 14644 (US)
(72) Inventor: Hu, Nan-Xing, Oakville Ontario L6H 7V3 (CA); Liu, Ping, Mississauga Ontario L5M 3H2 (CA); Wu, Yiliang, Oakville Ontario L6H 0C6 (CA)
(74) Representative: De Anna, Pier Luigi

(57) **Abstract**

A composition that may be used for an electronic circuit element includes a metal nanoparticle, an adhesion promoter compound and a solvent. The adhesion promoter compound may be a hydrolytic silane with at least one organic functional moiety. A method of forming conductive features on a substrate includes depositing a composition containing metal nanoparticles, an adhesion promoter compound and a solvent onto a substrate, and heating the deposited composition to a temperature from about 100°C to about 200°C.

## Description

Fabrication of electronic circuit elements using liquid deposition techniques is of profound interest as such techniques provide potentially low-cost alternatives to conventional mainstream amorphous silicon technologies for electronic applications such as thin film transistors (TFTs), light-emitting diodes (LEDs), RFID tags, photovoltaics, and the like. However the deposition and/or patterning of functional electrodes, pixel pads, and conductive traces, lines and tracks which meet the conductivity, processing, and cost requirements for practical applications have been a great challenge.

Solution-processable conductors are of great interest for use in such electronic applications. Metal nanoparticle-based inks represent a promising class of materials for printed electronics. However, most metal nanoparticles, such as silver and gold metal nanoparticles, require large molecular weight stabilizers to ensure proper solubility and stability in solution. These large molecular weight stabilizers inevitably raise the annealing temperatures of the metal nanoparticles above 200°C in order to bum off the stabilizers, which temperatures are incompatible with most low-cost plastic substrates such as polyethylene terephthalate (PET) and polyethylene naphthalate (PEN) that the solution may be coated onto and can cause damage thereto.

Furthermore, current metal nanoparticle compositions have not adhered sufficiently well to substrates. Printed features from such metal nanoparticle compositions will be inevitably damaged by simply rubbing and/or contacting the surface of features. Thus, the poor adhesion of the metal nanoparticle may limit their use in certain applications, such as, for example, printed antennas.

### SUMMARY

There is therefore a need for conductive metal nanoparticle compositions with improved adhesion to a substrate, for example, wherein the metal nanoparticle cannot be removed from the substrate by a simple rubbing of the substrate.

The above and other issues are addressed by the present application, wherein in embodiments, the application relates to a composition comprising a metal nanoparticle, an adhesion promoter compound and a solvent.

In embodiments, described is a composition comprising a metal nanoparticle, an adhesion promoter compound and a solvent, wherein the adhesion promoter compound is a hydrolytic silane with at least one organic functional moiety.

In further embodiments, described is a method of forming conductive features on a substrate, the method comprising: providing a liquid composition containing metal nanoparticles, an adhesion promoter compound and a solvent, depositing the liquid composition onto the substrate to form deposited features, and heating the deposited features on the substrate to a temperature from about 100°C to about 200°C to form conductive features on the substrate.

### EMBODIMENTS

Described herein is a composition containing metal nanoparticles and exhibiting improved adhesion to the surface of a substrate. The composition is comprised of a metal nanoparticle solution that may optionally contain a stabilizer, an adhesion promoter compound and a solvent. After the composition is printed onto a substrate, the substrate is annealed to form conductive metal features on a substrate.

The term "nano" as used in "metal nanoparticles" refers to, for example, a particle size of less than about 1,000 nm, such as, for example, from about 0.5 nm to about 1,000 nm, for example, from about 1 nm to about 500 nm, from about 1 nm to about 100 nm, from about 1 nm to about 25 nm or from about 1 to about 10 nm. The particle size refers to the average diameter of the metal particles, as determined by TEM (transmission electron microscopy) or other suitable method.

The metal nanoparticle solution herein includes a metal nanoparticle in a liquid solution. In embodiments, the metal nanoparticles are composed of (i) one or more metals or (ii) one or more metal composites. Suitable metals may include, for example, Al, Ag, Au, Pt, Pd, Cu, Co, Cr, In, and Ni, particularly the transition metals, for example, Ag, Au, Pt, Pd, Cu, Cr, Ni, and mixtures thereof. Silver may be used as a suitable metal. Suitable metal composites may include Au-Ag, Ag-Cu, Ag-Ni, Au-Cu, Au-Ni, Au-Ag-Cu, and Au-Ag-Pd. The metal composites may also include non-metals, such as, for example, Si, C, and Ge. The various components of the metal composite may be present in an amount ranging for example from about 0.01 % to about 99.9% by weight, particularly from about 10% to about 90% by weight.

In embodiments, the metal composite is a metal alloy composed of silver and one, two or more other metals, with silver comprising, for example, at least about 20% of the nanoparticles by weight, particularly greater than about 50% of the nanoparticles by weight.

Unless otherwise noted, the weight percentages recited herein for the components of the metal nanoparticles in the solution do not include the stabilizer.

The metal nanoparticles may be a mixture of two or more bimetallic metal nanoparticle species, such as those described in commonly assigned U.S. Patent Application No. 12/113,628 to Naveen Chopra et al. filed May 1, 2008 or a bimodal metal nanoparticle, such as those described in U.S. Patent Application No. 12/133,548 to Michelle N. Chretien filed June 5, 2008.

If the metal nanoparticle is silver, the silver nanoparticles have a stability (that is, the time period where there is minimal precipitation or aggregation of the silver-containing nanoparticles) of, for example, at least about 1 day, or from about 3 days to about 1 week, from about 5 days to about 1 month, from about 1 week to about 6 months, from about 1 week to over 1 year.

The composition further comprises an adhesion promoter compound. The adhesion promoter compound may be a silane compound with at least one organic functional moiety. The silane moiety of the adhesion promoter compound binds the adhesion promoter compound to the substrate, while the at least one organic functional moiety adsorbs to the surface of the metal nanoparticle or to the surface of a stabilizer directly attached to the metal nanoparticle. Furthermore, the adhesion promoter compound must be compatible with jettability and stability requirements for the ink formation.

In embodiments, the adhesion promoter compound may be a hydrolytic silane with at least one organic functional moiety. Examples of the hydrolytic silane with at least one organic functional moiety may include an alkoxysilane with at least one organic functional moiety, a chlorosilane with at least one organic functional moiety or an acetoxysilane with at least one organic functional moiety. The at least one organic functional moiety of the hydrolytic compound may be selected from the group consisting of an epoxy moiety, an acrylate moiety, a methacrylate moiety, an amino moiety, an acetyl moiety, a cyano moiety, a halogen moiety, a mercapto moiety, a sulfide moiety, a vinyl moiety, an alkoxyalkyl moiety, a carbamate moiety, a carboxyl moiety, an ester moiety, an aromatic moiety, and an alkyl moiety.

The alkoxysilane with at least one organic functional moiety may be represented by formula (1)

(Y)ₓ-Si-(OR)₄₋ₓ (1)

wherein x is 1, 2 or 3; OR is a hydrolysable alkoxy group; R is an alkyl; and Y is a organic functional moiety.

In embodiments, each Y of the alkoxysilane may independently include at least one organic functional moiety selected from the group consisting of epoxy, acrylate, methacrylate, amino, acetyl, cyano, halogen, mercapto, vinyl, alkoxyalkyl, carbamate, carboxyl, sulfide ester, aromatic, or alkyl (straight, branched, or cyclic) functional moieties. Furthermore, each Y of the alkoxysilane may independently have from 1 to about 100 carbon atoms, from about 1 to about 75 carbon atoms, from about 2 to about 50 carbon atoms, from about 2 to 40 carbon atoms or from about 2 to about 30 carbon atoms. Still further, each alkyl group R of the alkoxysilane may independently have from about 1 to 20 carbon atoms, from about 1 to about 15 carbon atoms, from about 1 to about 10 carbon atoms, from about 1 to about 8 carbon atoms or from about 1 to about 4 carbon atoms.

Examples of suitable alkoxysilanes may include alkoxysilanes with epoxy functionalities. The epoxy functionality may be a simple or substituted oxirane, a glycidyl group, a glycidyloxy group, a cyclohexaneoxide (epoxycyclohexyl) or cyclopentaneoxide (epoxycyclopentyl) polymerizable group. Examples of epoxy functional alkoxysilane monomers suitable for the composition may include
3-glycidoxymethyltrimethoxysilane, 3-glycidoxymethyltriethoxysilane,
3-glycidoxymethyltripropoxysilane, 3-glycidoxymethyltributoxysilane,
2-glycidoxyethyltrimethoxysilane, 2-glycidoxyethyltriethoxysilane,
2-glycidoxyethyltripropoxysilane, 2-glycidoxyethyltributoxysilane,
glycidoxyethyltriethoxysilane, glycidoxyethyl-tripropoxysilane,
glycidoxyethyltributoxysilane, 3-glycidoxypropyltrimethoxysilane,
3- glycidoxypropyltriethoxysilane, 3-glycidoxypropyltripropoxysilane,
3-glycidoxypropyltributoxysilane, 2-glycidoxypropyltrimethoxysilane,
2-glycidoxyypropyltriethoxysilane, 2-glycidoxypropyltripropoxysilane,
2-glycidoxypropyltributoxysilane, 1-glycidoxypropyltriethoxysilane,
1-glycidoxypropyltrimethoxysilane, 1-glycidoxypropyltripropoxysilane,
1-glycidoxypropyltributoxysilane, 3-glycidoxybutyltrimethoxysilane,
4-glycidoxybutyltriethoxysilane, 4-glycidoxybutyltripropoxysilane,
4-glycidoxybutyltributoxysilane, 4-glycidoxybutyltrimethoxysilane,
3-glycidoxybutyltriethoxysilane, 3-glycidoxybutyltripropoxysilane,
3-propoxybutyltributoxysilane, 1-glycidoxybutyltrimethoxysilane,
1-glycidoxybutyltriethoxysilane, 1-glycidoxybutyltripropoxysilane,
1-glycidoxybutyltributoxysilane, 2-epoxypropyltrimethoxysilane,
2-epoxypropyltriethoxysilane, (3,4-epoxycyclohexyl)-methyltrimethoxysilane,
(3,4-epoxycyclohexyl)-methyltriethoxysilane, (3,4-epoxycyclohexyl)-methyltripropoxysilane, (3,4-epoxycyclohexyl)-methyltributoxysilane,
(3,4-epoxycyclohexyl)-ethyltrimethoxysilane, (3,4-epoxycyclohexyl)-ethyltriethoxysilane, (3,4-epoxycyclohexyl)-ethyltripropoxysilane,
(3,4-epoxycyclohexyl)-ethyltributoxysilane, (3,4-epoxycyclohexyl)-propyltrimethoxysilane, (3,4-epoxycyclohexyl)-propyltriethoxysilane,
(3,4-epoxycyclohexyl)-propyltripropoxysilane, (3,4-epoxycyclohexyl)-propyltributoxysilane, (3,4-epoxycyclohexyl)-butyltrimethoxysilane,
(3,4-epoxycyclohexyl)-butyltriethoxysilane, (3,4-epoxycyclohexyl)-butyltripropoxysilane, (3,4-epoxycyclohexyl)-butyltributoxysilane, and
3-glycidoxyproyltriethoxysilane, mixtures thereof, and the like.

Examples of suitable alkoxysilanes with acrylate or methacrylate functionalities may include (3-methacryloxypropyl)trimethoxysilane, (3-methacryloxypropyl)triethoxysilane, (3-acryloxypropyl)trimethoxysilane, (3-acryloxypropyl)methlyldimethoxysilane, (3-acryloxypropyl) dimethylmethoxysilane, (methacryloxymethyl)dimethylethoxysilane, methacryloxymethyltrimethoxysilane, methacryloxymethyltriethoxysilane, mixtures thereof, and the like.

Examples of suitable alkoxysilanes with amino functional groups may include 2-aminoethyltrimethoxysilane, 2-aminoethyltriethoxysilane, 2-aminoethyltributoxysilane, 2-aminoethyltripropoxysilane, aminoethyltrimethoxysilane, aminoethyltriethoxysilane, aminomethyltriethoxysilane, 3-aminopropyltrimethoxysilane, 3-aminopropyltriethoxysilane,
3-aminopropyltributoxysilane, 3-aminopropyltripropoxysilane,
2-aminopropyltrimethoxysilane, 2-aminopropyltriethoxysilane,
2-aminopropyltripropoxysilane, 2-aminopropyltributoxysilane,
1-aminopropyltrimethoxysilane, 1-aminopropyltriethoxysilane,
1-aminopropyltributoxysilane, 1-aminopropyltripropoxysilane,
N-aminomethylamino ethyltrimethoxysilane,
N-aminomethylaminomethyltripropoxysilane, N-aminomethyl-2-aminoethyltrimethoxysilane, N-aminomethyl-2-aminoethyltriethoxysilane,
N-aminoethyl-2-aminoethyltripropoxysilane, N-aminomethyl-3-aminopropyltrimethoxysilane, N-aminomethyl-3-aminopropyltriethoxysilane,
N-aminomethyl-3-aminopropyltripropoxysilane, N-aminomethyl-2-aminopropyltriethoxysilane, N-aminomethyl-2-aminopropyltripropoxysilane,
N-aminopropyltripropoxysilane, N-aminopropyltrimethoxysilane,
N-(2-aminoethyl)-2-aminoethyltrimethoxysilane, N-(2-aminoethyl)-2-aminoethyltriethoxysilane, N-(2-aminoethyl)-2-aminoethyltripropoxysilane,
N-(2-aminoethyl)-aminoethyltriethoxysilane, N-(2-aminoethyl)-aminoethyltripropoxysilane, N-(2-aminoethyl)-2-aminopropyltrimethoxysilane,
N-(2-aminoethyl)-3-aminopropyltriethoxysilane, N-(2-aminoethyl)-3-aminopropyltripropoxysilane, N-(2-aminoethyl)-3-aminopropyltrimethoxysilane,
N-(2-aminoethyl)-2-aminopropyltriethoxysilane, N-(2-aminoethyl)-2-aminopropyltripropoxysilane, N-(2-aminopropyl)-2-aminoethyltrimethoxysilane,
N-(3-aminopropyl)-2-aminoethyltriethoxysilane, N-(3-aminopropyl)-2-aminoethyltripropoxysilane, N-methylaminopropyltriethoxysilane,
N-methylaminopropyltrimethoxysilane, 2-aminopropylmethyldiethoxysilane, 3-diethylenetriaminopropyltriethoxysilane, N-(2-aminoethyl)-3-aminoisobutylmethyldiethoxysilane, (aminoethylaminomethyl)phenethyl-trimethoxysilane,
(aminoethylaminomethyl)phenethyl-triethoxysilane,
(aminoethylaminomethyl)phenethyl-dimethoxymethylsilane,
3-(amonophenoxy)propyltrimethoxysilane, 3-(amonophenoxy)propyltriethoxysilane, 3-(amonophenoxy)propyldimethoxymethylsilane, aminophenyltrimethoxysilane, aminophenyltriethoxysilane, aminophenyldimethoxymethylsilane, aminophenyldiethoxymethylsilane, mixtures thereof, and the like.

Examples of suitable alkoxysilanes with acetyl functional groups include acetoxymethyltriethoxysilane, acetoxymethyltrimethoxysilane, acetoxypropyltrimethoxysilane, mixtures thereof, and the like.

Examples of suitable alkoxysilanes with cyano functional groups include 2-cyanoethyltrimethoxysilane, 2-cyanoethyltriethoxysilane, 3-cyanopropyltrimethoxysilane, 3-cyanopropylmethyldimethoxysilane, 3-isocyanopropyltrimethoxysilane, 3-cyanopropyltrimethoxysilane, 3-cyanopropyltriethoxysilane, bis(3-cyanopropyl)dimethoxysilane, mixtures thereof, and the like.

Examples of suitable alkoxysilanes with halogen functional groups include 3-bromopropyltrimethoxysilane, 3-chloropropyltrimethoxysilane,
3-chloroethyltrimethoxysilane, 2-chloroethyltriethoxysilane,
3-chloropropyltriethoxysilane, chloromethyltriethoxysilane, chloromethyltrimethoxysilane, 2-(4-chlorosulfonylphenyl)ethyltrimethoxysilane, (3,3,3-trifluoropropyl)trimethoxysilane, (tridecafluoro-1,1,2,2-tetrahydrooctyl)triethoxysilane, (heptadecafluoro-1,1,2,2-tetrahydrododecyl)triethoxysilane,
pentafluorophenylpropyltrimethoxysilane,
1,1-bromoundecyltrimethoxysilane, chloromethylmethyldiethoxysilane,
chloromethylmethyldiisopropoxysilane, ((chloromethyl)phenylethyl)-trimethoxysilane,
p-chloromethylphenyltrimethoxysilane,
p-chloromethylphenyltriisopropylsilane, 3-iodopropyltrimethoxysilane, mixtures thereof, and the like.

Examples of suitable alkoxysilanes with mercapto functional groups may include 3-mercaptopropyltrimethoxysilane, 3-mercaptopropyltriethoxysilane, 3-mercaptomethylmethyldiethoxysilane, 3-mercaptopropylmethyldimethoxysilane, mercaptomethylmethyldiethoxysilane, [3-triethoxysilyl]propyl]-disulfide, [3-trimethoxysilyl]propyl]-disulfide, [3-diethoxymethylsilyl]propyl]-disulfide bis[3-triethoxysilyl]propyl]-tetrasulfide, [3-diethoxymethylsilyl]propyl]-tetrasulfide, [3-trimethoxysilyl]propyl]-tetrasulfide, mixtures thereof, and the like.

Examples of suitable alkoxysilanes with vinyl functional groups may include butenyltriethoxysilane, vinyltrimethoxysilane, vinyltriethoxysilane, vinyltrisopropoxysilane, allyldimethoxysilane, allyltrimethoxysilane, allyltriethoxysilane, [2-(3-cyclohexenyl)ethyl]trimethoxysilane, [2-(3-cyclohexenyl)ethyl]triethoxysilane, 3-(N-allylamino)propyltrimethoxysilane, 2-(chloromethyl)allyltrimethoxysilane, 5-(bicycloheptenyl)triethoxysilane, mixtures thereof, and the like.

Examples of suitable alkoxysilanes with aromatic functional groups include phenethyltrimethoxysilane, phenyltrimethoxysilane, benzyltriethoxysilane, phenyltriethoxysilane, mixtures thereof, and the like.

Examples of suitable alkoxysilanes with alkyl functional groups include methyltrimethoxysilane, ethyltrimethoxysilane, propyltrimethoxysilane, butyltrimethoxysilane, isobutyltrimethoxysilane, n-butyltrimethoxysilane, hexyltrimethoxysilane, hexadecyltrimethoxysilane, octyltrimethoxysilane, isoctyltrimethoxysilane, decyltrimethoxysilane, allyltrimethoxysilane, cyclohexyltrimethoxysilane, cyclohexylmethyltrimethoxysilane, 2-(3-cyclohexenyl)ethyltrimethoxysilane, cyclopentyltrimethoxysilane, methyltriethoxysilane, ethyltriethoxysilane, propyltriethoxysilane, butyltriethoxysilane, isobutyltriethoxysilane, hexyltriethoxysilane, pentyltriethoxysilane, octyltriethoxysilane, cyclohexyltriethoxysilane,
n-decyltriethoxysilane, dodecyltriethoxysilane, cyclohexylmethyltriethoxysilane, dimethyldimethoxysilane, diethyldiethoxysilane, mixtures thereof, and the like.

Examples of suitable alkoxysilanes with alkoxyalkyl functional groups include 3-methoxypropyltrimethoxysilane, 3-ethoxypropyltrimethoxysilane,
3-propxypropyltrimethoxysilane, 3-methoxyethyltrimethoxysilane,
3-ethoxyethyltrimethoxysilane, 3-propoxyethyltrimethoxysilane,
2-[methoxy(polethyleneoxy)propyl]heptamethyltrisiloxane,
[methoxy(polyethyleneoxy)propyl]trimethoxysilane,
[methoxy(polyethyleneoxy)ethyl]trimethoxysilane,
[methoxy(polyethyleneoxy)ethyl]triethoxysilane,
[methoxy(polyethyleneoxy)ethyl]trimethoxysilane, mixtures thereof and the like.

The adhesion promoter may be present in the composition in an amount of at least 0.1 weight percent of the composition, such as for example from about 0.1 weight percent to about 10 weight percent, from about 0.5 weight percent to about 10 weight percent, from about 1 weight percent to about 8 weight percent, from about 2 weight percent to about 6 weight percent, from about 3 weight percent to about 5 weight percent, and from about 0.5 to about 2 weight percent of the composition.

The metal nanoparticle solution may also contain an organic stabilizer that is connected to the surface of the metal nanoparticles and is not removed until the annealing of the metal nanoparticles during formation of metal features on a substrate.

In embodiments, the stabilizer complex is physically or chemically associated with the surface of the metal nanoparticles. In this way, the nanoparticles have the stabilizer thereon outside of a liquid solution. That is, the nanoparticles with the stabilizer thereon may be isolated and recovered from a reaction mixture solution used in forming the nanoparticles and stabilizer complex. The stabilized nanoparticles may thus be subsequently readily and homogeneously dispersed in a solvent for forming a printable solution.

As used herein, the phrase "physically or chemically associated" between the metal nanoparticles and the stabilizer can be a chemical bond and/or other physical attachment. The chemical bond can take the form of, for example, covalent bonding, hydrogen bonding, coordination complex bonding, or ionic bonding, or a mixture of different chemical bonds. The physical attachment can take the form of, for example, van der Waals' forces or dipole-dipole interaction, or a mixture of different physical attachments.

The term "organic" in "organic stabilizer" refers to, for example, the presence of carbon atom(s), but the organic stabilizer may include one or more nonmetal heteroatoms such as nitrogen, oxygen, sulfur, silicon, halogen, and the like. The organic stabilizer may be an organoamine stabilizer such as those describe in U.S. Patent No. 7,270,694. Examples of the organoamine are an alkylamine, such as for example butylamine, pentylamine, hexylamine, heptylamine, octylamine, nonylamine, decylamine, hexadecylamine, undecylamine, dodecylamine, tridecylamine, tetradecylamine, diaminopentane, diaminohexane, diaminoheptane, diaminooctane, diaminononane, diaminodecane, diaminooctane, dipropylamine, dibutylamine, dipentylamine, dihexylamine, diheptylamine, dioctylamine, dinonylamine, didecylamine, methylpropylamine, ethylpropylamine, propylbutylamine, ethylbutylamine, ethylpentylamine, propylpentylamine, butylpentylamine, tributylamine, trihexylamine, and the like, or mixtures thereof.

Examples of other organic stabilizers include, for example, thiol and its derivatives, -OC(=S)SH (xanthic acid), polyethylene glycols, polyvinylpyridine, polyninylpyrolidone, and other organic surfactants. The organic stabilizer may be selected from the group consisting of a thiol such as, for example, butanethiol, pentanethiol, hexanethiol, heptanethiol, octanethiol, decanethiol, and dodecanethiol; a dithiol such as, for example, 1,2-ethanedithiol, 1,3-propanedithiol, and 1,4-butanedithiol; or a mixture of a thiol and a dithiol. The organic stabilizer may be selected from the group consisting of a xanthic acid such as, for example, O-methylxanthate, O-ethylxanthate, O-propylxanthic acid, O-butylxanthic acid, O-pentylxanthic acid, O-hexylxanthic acid, O-heptylxanthic acid, O-octylxanthic acid, O-nonylxanthic acid, O-decylxanthic acid, O-undecylxanthic acid, O-dodecylxanthic acid. Organic stabilizers containing a pyridine derivative (for example, dodecyl pyridine) and/or organophosphine that can stabilize metal nanoparticles may also be used as a potential stabilizer.

Further examples of organic stabilizers may include: the carboxylic acid-organoamine complex stabilized metal nanoparticles, described in U.S. Patent Application No. 11/950,450 to Yuning Li filed December 5, 2007; the carboxylic acid stabilizer metal nanoparticles described in U.S. Patent App. Pub. No. 2007/0099357 A1, and the thermally removable stabilizer and the UV decomposable stabilizers described in U.S. Patent Application No. 12/013,539 to Yuning Li filed January 14, 2008.

The extent of the coverage of stabilizer on the surface of the metal nanoparticles can vary, for example, from partial to full coverage depending on the capability of the stabilizer to stabilize the metal nanoparticles. Of course, there is variability as well in the extent of coverage of the stabilizer among the individual metal nanoparticles.

The weight percentage of the optional stabilizer in the metal nanoparticle solution may be from, for example, about 5 weight percent to about 80 weight percent, from about 10 weight percent to about 60 weight percent or from about 15 weight percent to about 50 weight percent.

The composition comprised of the metal nanoparticles and the adhesion promoter compound may be produced by dispersing the metal nanoparticles and the adhesion promoter compound in any suitable dispersing solvent and depositing the composition on substrate. The composition may be used to print and form metal features on a substrate.

The weight percentage of the metal nanoparticles in the dispersed composition may be from, for example, about 5 weight percent to about 80 weight percent, from about 10 weight percent to about 60 weight percent or from about 15 weight percent to about 50 weight percent. Examples of the dispersing solvent may include, for example, water, an alkyl alcohol having from 1 to about 16 carbon atoms, a cyclocarbyl alcohol having from about 5 to about 15 carbon atoms, an alkane having from about 6 to about 16 carbon atoms, an alkyl acetate having from about 3 to about 12 carbon atoms, toluene, xylene, mesitylene, chlorobenzene, dichlorobenzene, cyanobenzene, acetonitrile, N,N-dimethylformamide (DMF), N-methyl-2-pyrrolidone, and mixtures thereof. Further examples of dispersing solvents include the dispersing solvents disclosed in U.S. Patent Application No. 12/331,573.

One, two, three or more solvents may be used. In embodiments where two or more solvents are used, each solvent may be present at any suitable volume ratio or molar ratio such as for example from about 99(first solvent):1 (second solvent) to about 1 (first solvent):99(second solvent).

The fabrication of an electrically conductive element from the metal nanoparticle dispersion can be carried out by depositing the composition on a substrate using any suitable liquid deposition technique at any suitable time prior to or subsequent to the formation of other optional layer or layers on the substrate. Thus, liquid deposition of the composition on the substrate can occur either on a substrate or on a substrate already containing layered material, for example, a semiconductor layer and/or an insulating layer.

The phrase "liquid deposition technique" refers to, for example, deposition of a composition using a liquid process such as liquid coating or printing, where the liquid is a homogeneous or heterogeneous dispersion of the metal nanoparticles and the adhesion promoter compound. The metal nanoparticle composition may be referred to as an ink when deposited on a substrate. Examples of liquid coating processes may include, for example, spin coating, blade coating, rod coating, dip coating, and the like. Examples of printing techniques may include, for example, lithography or offset printing, gravure, flexography, screen printing, stencil printing, inkjet printing, stamping (such as microcontact printing), and the like. Liquid deposition deposits a layer of the composition having a thickness ranging from about 5 nanometers to about 5 millimeters, preferably from about 10 nanometers to about 1000 micrometers. The deposited metal nanoparticle composition at this stage may or may not exhibit appreciable electrical conductivity.

The metal nanoparticles can be spin-coated from the metal nanoparticles dispersion, for example, for about 10 seconds to about 1000 seconds, for about 50 seconds to about 500 seconds or from about 100 seconds to about 150 seconds, onto a substrate at a speed, for example, from about 100 revolutions per minute ("rpm") to about 5000 rpm, from about 500 rpm to about 3000 rpm and from about 500 rpm to about 2000 rpm.

The substrate upon which the metal features are deposited may be any suitable substrate, including, for example, silicon, glass plate, plastic film, sheet, fabric, or paper. For structurally flexible devices, plastic substrates, such as for example polyester, polycarbonate, polyimide sheets and the like may be used. The thickness of the substrate may be from amount 10 micrometers to over 10 millimeters with an exemplary thickness being from about 50 micrometers to about 2 millimeters, especially for a flexible plastic substrate and from about 0.4 to about 10 millimeters for a rigid substrate such as glass or silicon.

Heating the deposited composition at a temperature of, for example, at or below about 200°C, such as, for example, from about 80°C to about 200°C, from about 100°C to about 200°C, from about 100°C to about 180°C and from about 100°C to about 160°C, to induce the metal nanoparticles or "anneal" the metal nanoparticles to form an electrically conductive layer, which is suitable for use as an electrically conductive element in electronic devices. The heating temperature is one that does not cause adverse changes in the properties of previously deposited layer(s) or the substrate (whether single layer substrate or multilayer substrate). Also, the low heating temperatures described above allows the use of low cost plastic substrates, which have an annealing temperature below 200°C.

The heating can be performed for a time ranging from, for example, 1 second to about 10 hours and from about 10 seconds to 1 hour. The heating can be performed in air, in an inert atmosphere, for example, under nitrogen or argon, or in a reducing atmosphere, for example, under nitrogen containing from 1 to about 20 percent by volume hydrogen. The heating can also be performed under normal atmospheric pressure or at a reduced pressure of, for example, from about 1000 mbars to about 0.01 mbars.

As used herein, the term "heating" encompasses any technique(s) that can impart sufficient energy to the heated material or substrate to (1) anneal the metal nanoparticles and/or (2) remove the optional stabilizer from the metal nanoparticles. Examples of heating techniques may include thermal heating (for example, a hot plate, an oven, and a burner), infra-red ("IR") radiation, a laser beam, microwave radiation, or UV radiation, or a combination thereof.

Heating produces a number of effects. Prior to heating, the layer of the deposited metal nanoparticles may be electrically insulating or with very low electrical conductivity, but heating results in an electrically conductive layer composed of annealed metal nanoparticles, which increases the conductivity. In embodiments, the annealed metal nanoparticles may be coalesced or partially coalesced metal nanoparticles. In embodiments, it may be possible that in the annealed metal nanoparticles, the metal nanoparticles achieve sufficient particle-to-particle contact to form the electrically conductive layer without coalescence.

In embodiments, after heating, the resulting electrically conductive layer has a thickness ranging, for example, from about 5 nanometers to about 5 microns and from about 10 nanometers to about 2 microns.

The conductivity of the resulting metal element produced by heating the deposited metal nanoparticle composition is, for example, more than about 100 Siemens/centimeter ("S/cm"), more than about 1000 S/cm, more than about 2,000 S/cm, more than about 5,000 S/cm, or more than about 10,000 S/cm.

The resulting elements can be used as electrodes, conductive pads, thin-film transistors, conductive lines, conductive tracks, and the like in electronic devices such as thin film transistors, organic light emitting diodes, RFID (radio frequency identification) tags, photovoltaic, printed antenna and other electronic devices which require conductive elements or components.

In yet other embodiments, there is provided a thin film transistor comprising:
(a) an insulating layer;
(b) a gate electrode;
(c) a semiconductor layer;
(d) a source electrode; and
(e) a drain electrode,
wherein the insulating layer, the gate electrode, the semiconductor layer, the source electrode, and the drain electrode are in any sequence as long as the gate electrode and the semiconductor layer both contact the insulating layer, and the source electrode and the drain electrode both contact the semiconductor layer, and
wherein at least one of the source electrode, the drain electrode, and the gate electrode are formed by: providing a solution containing metal nanoparticles and an adhesion promoter compound, depositing the solution onto the substrate, and heating the solution on the substrate to a temperature from about 100°C to about 200 °C to form conductive features on the substrate.

A gate electrode, a source electrode, and a drain electrode may thus be fabricated by embodiments herein. The thickness of the gate electrode layer ranges for example from about 10 to about 2000 nm. Typical thicknesses of source and drain electrodes are, for example, from about 40 nm to about 1 micrometer with the more specific thickness being about 60 nanometers to about 400 nm.

The insulating layer generally can be an inorganic material film or an organic polymer film. Examples of inorganic materials suitable as the insulating layer may include, for example, silicon oxide, silicon nitride, aluminum oxide, barium titanate, barium zirconium titanate and the like. Illustrative examples of organic polymers for the insulating layer may include, for example, polyesters, polycarbonates, poly(vinyl phenol), polyimides, polystyrene, poly(methacrylate)s, poly(acrylate)s, epoxy resin and the like. The thickness of the insulating layer is, for example from about 10 nm to about 500 nm depending on the dielectric constant of the dielectric material used. An exemplary thickness of the insulating layer is from about 100 nm to about 500 nm. The insulating layer may have a conductivity that is, for example, less than about 10⁻¹² S/cm.

Situated, for example, between and in contact with the insulating layer and the source/drain electrodes is the semiconductor layer wherein the thickness of the semiconductor layer is generally, for example, about 10 nm to about 1 micrometer, or about 40 to about 100 nm. Any semiconductor material may be used to form this layer. Exemplary semiconductor materials include regioregular polythiophene, oligthiophene, pentacene, and the semiconductor polymers disclosed in U.S. Publication No. 2003/0160230 A1; U.S. Publication No. 2003/0160234 A1; U.S. Publication No. 2003/0136958 A1. Any suitable technique may be used to form the semiconductor layer. One such method is to apply a vacuum of about 10⁻⁵ torr to 10⁻⁷ torr to a chamber containing a substrate and a source vessel that holds the compound in powdered form, and heat the vessel until the compound sublimes onto the substrate. The semiconductor layer can also generally be fabricated by solution processes such as spin coating, casting, screen printing, stamping, or jet printing of a solution or dispersion of the semiconductor.

The insulating layer, the gate electrode, the semiconductor layer, the source electrode, and the drain electrode are formed in any sequence, particularly where in embodiments the gate electrode and the semiconductor layer both contact the insulating layer, and the source electrode and the drain electrode both contact the semiconductor layer. The phrase "in any sequence" includes sequential and simultaneous formation. For example, the source electrode and the drain electrode can be formed simultaneously or sequentially. The composition, fabrication, and operation of thin film transistors are described in U.S. Patent No. 6,107,117.

In embodiments, at least one of the gate, source or drain electrode in a thin-film transistor is formed by using a method described herein to form conductive features on a substrate, providing a solution containing stabilized metal nanoparticles and an adhesion promoter compound; depositing the solution onto the substrate, wherein during the deposition or following the deposition of the solution onto the substrate, and removing the stabilizer, at a temperature below about 200 °C, to form conductive features on the substrate.

The embodiments disclosed herein will now be described in detail with respect to specific exemplary embodiments thereof, it being understood that these examples are intended to be illustrative only and the embodiments disclosed herein is not intended to be limited to the materials, conditions, or process parameters recited herein. All percentages and parts are by weight unless otherwise indicated. Room temperature refers to a temperature ranging for example from about 20 to about 25 °C.

### EXAMPLE

### Preparation of Aminoalkane-Stabilized Silver Nanoparticles

The aminoalkane-stabilized silver nanoparticles were prepared by adding 20 grams of silver acetate to a 60°C mixture of hexadecylamine (289 g) in toluene (150 ml). The mixture was then stirred until the silver acetate was completely dissolved (in about 10 min). Subsequently, 7 grams of phenylhydrazine was slowly added to the mixture to form a resulting mixture, which was stirred for about one hour at 55 °C. Next, isopropanol (240 ml) and methanol (560 ml) were added to the resulting mixture. The product was collected by filtration and then stirred in isopropanol (200 ml) for 30 minutes. The product was subjected to a second filtration and dried under vaccum at room temperature for about 12 hours. The final product contains about 80 weight percent silver and about 20 weight percent hexadecylamine as silver nano particle stabilizer.

### Preparation of Ink Composition

An ink composition was prepared by adding 0.03 grams of aminopropyltrimethoxysilane to a mixture of 0.15 grams of hexadecylamine stabilized silver nanoparticles and 0.85 grams of toluene The ink composition, containing about 15 weight percent silver nanoparticles and about 3 weight percent aminopropyltrimethoxysilane, was stirred with a magnetic stir bar for about 3 hours and then spin coated on a glass slide at 1000 rpm for 2 minutes to form brown thin films of silver nanoparticles. The thin films of silver nanoparticles were heated in an oven at a temperature of 140°C for 10 minutes to anneal the silver nanoparticles, and form a shiny mirror-like thin film with a thickness of approximately 85 nm. The average conductivity of the annealed silver film was 2.41 x 10³ S/cm, as measured by KEITHLEY 4-Probes.

The adhesion of the silver nanoparticles to the substrate was tested by rubbing the coated substrate with cotton tipped applicators. After manually rubbing the cotton tipped applicators across the coated surface of the substrate with a certain amount of force (about 10 times), the annealed silver nanoparticle film remained coated on the substrate without any noticeable damage. Furthermore, the adhesion of the silver nanoparticles to the substrate was also tested by placing a piece of 3M SCOTCH (3/4 inch wide, 1 inch long) tape on the coated substrate. After the tape was peeled off, the annealed silver nanoparticle film remained intact and conductive.

### COMPARATIVE EXAMPLE

A comparative example ink composition was prepared by mixing 0.15 grams of hexadecylamine stabilized silver nanoparticles (from the above example) and 0.85 grams of toluene. The comparative example did not include any of the aminopropyltrimethoxysilane adhesion promoter. The comparative ink composition, containing 15 weight percent silver nanoparticles, was stirred with a magnetic stir bar for about 3 hours and then spin coated on a glass slide at 1000 rpm for 2 minutes to form brown thin films of silver nanoparticles. The thin films of silver nanoparticles were heated in an oven at a temperature of 140°C for 10 minutes to anneal the silver nanoparticles, and form a shiny mirror-like thin film with a thickness of approximately 85 nm. The average conductivity of the annealed silver film was 2.41 x 10³ S/cm, as measured using KEITHLEY 4-Probes.

The adhesion of the silver nanoparticles to the substrate was tested by rubbing the coated substrate with cotton tipped applicators. After manually rubbing the cotton tipped applicators across the coated surface of the substrate with a certain amount of force (about 10 times), the annealed silver nanoparticle film was significantly damaged; resulting in a non-conductive silver nanoparticle film. Furthermore, the adhesion of the silver nanoparticles to the substrate was also tested by placing a piece of 3M SCOTCH (3/4 inch wide, 1 inch long) tape on the coated substrate. After the tape was peeled off, the annealed silver nanoparticle film was significantly damaged, and non-conductive.

It will be appreciated that various of the above-disclosed and other features and functions, or alternatives thereof, may be desirably combined into many other different systems or applications. Also, various presently unforeseen or unanticipated alternatives, modifications, variations or improvements therein may be subsequently made by those skilled in the art, and are also intended to be encompassed by the following claims.

## Claims

1. A composition comprising a metal nanoparticle, an adhesion promoter compound and a solvent.

2. The composition of claim 1, wherein the metal nanoparticle is selected from the group consisting of silver, gold, platinum, palladium, copper, cobalt, chromium, nickel, silver-copper composite, silver-gold-copper composite, silver-gold-palladium composite and mixtures thereof.

3. The composition of claim 1, wherein the adhesion promoter compound is a hydrolytic silane compound with at least one organic functional moiety.

4. The composition of claims 1 or 3, wherein the metal nanoparticle further comprise a stabilizer; preferably the stabilizer is an organoamine stabilizer selected from the group consisting butylamine, pentylamine, hexylamine, heptylamine, octylamine, nonylamine, decylamine, hexadecylamine, undecylamine, dodecylamine, tridecylamine, tetradecylamine, diaminopentane, diaminohexane, diaminoheptane, diaminooctane, diaminononane, diaminodecane, diaminooctane, dipropylamine, dibutylamine, dipentylamine, dihexylamine, diheptylamine, dioctylamine, dinonylamine, didecylamine, methylpropylamine, ethylpropylamine, propylbutylamine, ethylbutylamine, ethylpentylamine, propylpentylamine, butylpentylamine, tributylamine, trihexylamine and mixtures thereof.

5. The composition of claim 3, wherein the at least one organic functional moiety of the hydrolytic silane compound is selected from the group consisting of:
• an epoxy moiety, an acrylate moiety, a methacrylate moiety, an amino moiety, an acetyl moiety, a cyano moiety, a halogen moiety, a mercapto moiety, a sulfide moiety, a vinyl moiety, an alkoxyalkyl moiety, a carbamate moiety, a carboxyl moiety, an ester moiety, an aromatic moiety, and an alkyl moiety; or
• a sulfide moiety, an amino moiety and a mercapto moiety.

6. The composition of claim 1, wherein the adhesion promoter compound is from about 0.1 to about 10 weight percent of the composition.

7. The composition of claim 1, wherein the solvent is selected from the group consisting of water, an alkyl alcohol having from 1 to about 16 carbon atoms, a cyclocarbyl alcohol having from about 5 to about 15 carbon atoms, an alkane having from about 6 to about 16 carbon atoms, an alkyl acetate having from about 3 to about 12 carbon atoms, toluene, xylene, mesitylene, chlorobenzene, dichlorobenzene, cyanobenzene, acetonitrile, N,N-dimethylformamide (DMF), N-methyl-2-pyrrolidone, and combinations thereof.

8. The composition of claim 3, wherein the metal nanoparticle is selected from the group consisting of silver, gold, platinum, palladium, copper, cobalt, chromium, nickel, silver-copper composite, silver-gold-copper composite, silver-gold-palladium composite and mixtures thereof.

9. The composition of claim 3, wherein the at least one organic functional moiety of the hydrolytic silane compound is selected from the group consisting of an epoxy moiety, an acrylate moiety, a methacrylate moiety, an amino moiety, an acetyl moiety, a cyano moiety, a halogen moiety, a mercapto moiety, a sulfide moiety, a vinyl moiety, an alkoxyalkyl moiety, a carbamate moiety, a carboxyl moiety, an ester moiety, an aromatic moiety and an alkyl moiety.

10. The composition of claim 3, wherein the at least one organic functional moiety of the hydrolytic silane compound is selected from the group consisting of a sulfide moiety, an amino moiety and a mercapto moiety.

11. A method of forming conductive features on a substrate, the method comprising:
providing a liquid composition containing metal nanoparticles, an adhesion promoter compound and a solvent,
depositing the liquid composition onto the substrate to form deposited features, and
heating the deposited features on the substrate to a temperature from about 100°C to about 200°C to form conductive features on the substrate.

12. The method according to claim 11, wherein the adhesion promoter compound is a hydrolytic silane with at least one organic functional moiety.

13. The method according to claim 12, wherein the at least one organic functional moiety of the hydrolytic silane compound is selected from the group consisting of an epoxy moiety, an acrylate moiety, a methacrylate moiety, an amino moiety, an acetyl moiety, a cyano moiety, a halogen moiety, a mercapto moiety, a sulfide moiety , a vinyl moiety, an alkoxyalkyl moiety, a carbamate moiety, a carboxyl moiety, an ester moiety, an aromatic moiety and an alkyl moiety.

14. The method according to claim 11, wherein the metal nanoparticle further comprise a stabilizer.

15. The method according to claim 11, wherein the liquid depositing is selected from the group consisting of spin coating, blade coating, rod coating, dip coating, lithography or offset printing, gravure, flexography, screen printing, stencil printing, inkjet printing, and stamping.
